# EUROPEAN PATENT APPLICATION

(11) **EP 4 545 361 A1**
(43) Date of publication of application: **30.04.2025**
(21) Application number: 23860709.7
(22) Date of filing: 31.07.2023
(51) Int. Cl.: B60R 16/023, H05K 5/03, B60R 16/02, H05K 9/00

(54) **FUSE BOX COVER UNIT AND TERMINAL COUPLING APPARATUS FOR VEHICLE COMPRISING SAME**

(30) Priority: 31.08.2022 KR 20220110381
(71) Applicant: LG Energy Solution, Ltd., Seoul 07335 (KR)
(72) Inventor: CHOI, Jin-Hwee, Daejeon 34122 (KR)
(74) Representative: Plasseraud IP
(86) International application number: PCT/KR2023/011153
(87) International publication number: WO 2024/049028

(57) **Abstract**

The present disclosure provides a fuse box cover unit that makes it easy to mount an electronic connector in a fuse box of a vehicle and a terminal coupling apparatus for vehicles comprising the same. A fuse box cover unit according to an embodiment of the present disclosure seals a fuse box mounted in an inside of a vehicle, wherein an electronic connector connectable to an electronic slot formed in the fuse box is integrally formed.

## Description

### TECHNICAL FIELD

The present disclosure relates to a fuse box cover unit and a terminal coupling apparatus for vehicles comprising the same, and more particularly, to a fuse box cover unit that makes it easy to mount an electronic connector in a fuse box of a vehicle and a terminal coupling apparatus for vehicles comprising the same.

The present application claims priority to Korean Patent Application No. 10-2022-0110381 filed on August 31, 2022 in the Republic of Korea, the disclosure of which is incorporated herein by reference.

### BACKGROUND ART

Recently, a variety of electrical and electronic devices used in vehicles are emerging. The electrical and electronic devices include, for example, a black box, a navigation, a number plate, monitoring equipment, diagnostic equipment and so on. Basically, the variety of electrical and electronic devices used in vehicles are designed to operate using power from main batteries mounted in the vehicles.

In general, these electrical and electronic devices are installed in a fuse box or a box-shaped space in which electronic components such as fuses or relays are housed in the vehicle. The fuse box also accommodates electronic terminals such as an On Board Diagnosis (OBD) slot for connection to an electronic system such as OBD.

More recently, with the widespread use of electric vehicles, there is an increasing connection of an automotive OBD connector to the OBD slot in the fuse box. When automotive diagnosis is needed, the automotive OBD connector is connected to the OBD slot in the fuse box to acquire or store detailed battery data of the vehicle and wirelessly transmit the data to a server to make use of the data.

However, for the connection between the electronic connector such as the OBD connector and the electronic slot such as the OBD slot, it is necessary to separate a fuse box cover from the fuse box, so the exposure of wires to the inside of the vehicle is unavoidable and the separated fuse box cover is disposed in the inside of the vehicle, causing inconvenience in mounting and visual discomfort to users.

Therefore, there is a need for an approach to guide easy mounting of the electronic connector such as the OBD connector when connecting the electronic connector.

### SUMMARY

### Technical Problem

The present disclosure is designed to solve the above-described problem, and therefore the present disclosure is directed to providing a fuse box cover unit for guiding easy mounting of an electronic connector and a terminal coupling apparatus for vehicles comprising the same.

The present disclosure is further directed to providing a fuse box cover unit for preventing interference and improving space utilization when mounting the electronic connector and a terminal coupling apparatus for vehicles comprising the same.

The technical problem to be solved by the present disclosure is not limited to the above-described problems, and these and other problems will be clearly understood by those skilled in the art from the following description.

### Technical Solution

To solve the above-described problem, the present disclosure provides a fuse box cover unit which seals a fuse box mounted in an inside of a vehicle, wherein an electronic connector connectable to an electronic slot formed in the fuse box is integrally formed.

Preferably, the electronic connector may be disposed on a rear side of the fuse box cover unit opposite a front side that is exposed to the inside of the vehicle when the fuse box cover unit is mounted.

Preferably, the fuse box cover unit may include a cover body that is detachably coupled to the fuse box; an electronic PCB disposed on a rear surface of the cover body; a connection wire of a predetermined length connected to the electronic PCB; and an electronic connector mounted at an end portion of the connection wire.

Preferably, the fuse box cover unit may include a PCB case covering the electronic PCB, and the PCB case may have a wire groove to allow the connection wire to pass through.

Preferably, the PCB case may include an electromagnetic wave shielding material.

Preferably, the electromagnetic wave shielding material may include an electromagnetic wave shielding sheet and be attached to an inner surface of the PCB case.

Preferably, the fuse box cover unit may include a cover handle formed in the cover body and having slot shape of a predetermined size.

Preferably, the rear surface of the cover body may have at least one PCB fixing portion for fixing the electronic PCB.

Preferably, the electronic connector may be an OBD connector.

The present disclosure further provides a terminal coupling apparatus for a vehicle, including the fuse box cover unit according to the above-described embodiments; and a fuse box mounted in an inside of the vehicle.

### Advantageous Effects

According to the various embodiments of the present disclosure, it may be possible to provide the fuse box cover unit for guiding easy mounting of the electronic connector and the terminal coupling apparatus for vehicles comprising the same.

Additionally, according to the various embodiments of the present disclosure, it may be possible to provide the fuse box cover unit for preventing interference and improving space utilization when mounting the electronic connector and the terminal coupling apparatus for vehicles comprising the same.

Many other additional effects may be achieved by many other embodiments of the present disclosure. These effects of the present disclosure are described in detail in each embodiment, or regarding effects that can be easily understood by those skilled in the art, the corresponding description is omitted.

### BRIEF DESCRIPTION OF THE DRAWINGS

The accompanying drawings illustrate exemplary embodiments of the present disclosure and together with the following detailed description, serve to provide a further understanding of the technical aspect of the present disclosure, and thus the present disclosure should not be construed as being limited to the drawings.
FIG. 1 is a diagram illustrating a terminal coupling apparatus for vehicles according to an embodiment of the present disclosure.
FIG. 2 is a schematic cross-sectional view of the terminal coupling apparatus for vehicles of FIG. 1.
FIG. 3 is a diagram illustrating a fuse box cover unit of the terminal coupling apparatus for vehicles of FIG. 2.
FIG. 4 is a schematic rear perspective view of the fuse box cover unit of FIG. 3.
FIG. 5 is a diagram of the fuse box cover unit of FIG. 4 excluding a printed circuit board (PCB) case.
FIG. 6 is a diagram illustrating a cover body of the fuse box cover unit of FIG. 4.
FIG. 7 is a diagram illustrating a PCB case of the fuse box cover unit of FIG. 3.
FIG. 8 is a schematic rear perspective view of the PCB case of FIG. 7.
FIG. 9 is a diagram illustrating an interference prevention mechanism through the fuse box cover unit of FIG. 2.

### DETAILED DESCRIPTION

Hereinafter, exemplary embodiments of the present disclosure will be described in detail with reference to the accompanying drawings. Prior to the description, it should be understood that the terms or words used in the specification and the appended claims should not be construed as being limited to general and dictionary meanings, but rather interpreted based on the meanings and concepts corresponding to the technical aspect of the present disclosure on the basis of the principle that the inventor is allowed to define the terms appropriately for the best explanation.

Therefore, the embodiments described herein and the illustrations shown in the drawings are exemplary embodiments of the present disclosure to describe the technical aspect of the present disclosure and are not intended to be limiting, so it should be understood that a variety of other equivalents and modifications could have been made thereto at the time that the application was filed.

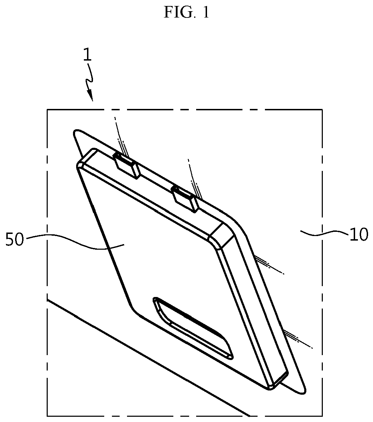

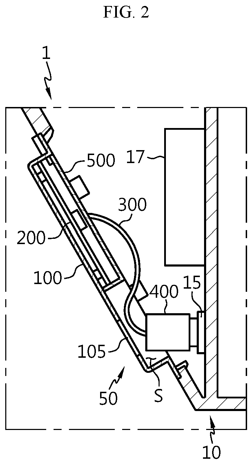

FIG. 1 is a diagram illustrating a terminal coupling apparatus for vehicles according to an embodiment of the present disclosure, and FIG. 2 is a schematic cross-sectional view of the terminal coupling apparatus for vehicles of FIG. 1.

Referring to FIGS. 1 and 2, the terminal coupling apparatus 1 for vehicles may be installed in a vehicle, and include a fuse box 10 mounted in the inside of the vehicle and a fuse box cover unit 50 to seal the fuse box 10.

The vehicle may be an electric vehicle using a battery as an energy source. The battery may be a secondary battery, for example, a cylindrical secondary battery, a prismatic secondary battery or a pouch type secondary battery.

The fuse box 10 may be a box-shaped space in which an electronic unit 17 such as fuses or relays are housed in the vehicle. The fuse box 10 may also accommodate an electronic slot 15 such as an On Board Diagnosis (OBD) slot for connection to an electronic system such as OBD.

The fuse box cover unit 50 may be configured to open and close the fuse box 10 by user manipulation, and an electronic connector 400 that is connectable to the electronic slot 15 in the fuse box 10 may be integrally formed with the fuse box cover unit 50.

In this embodiment, since the electronic connector 400 is integrally formed with the fuse box cover unit 50, it may be possible to guide easier connection of the electronic connector 400 to the electronic slot 15.

Here, the electronic connector 400 may be disposed on the rear side of the fuse box cover unit 50 opposite the front side that is exposed to the inside of the vehicle when the fuse box cover unit 50 is mounted.

In this embodiment, since the electronic connector 400 disposed in the fuse box cover unit 50 is disposed on the rear side of the fuse box cover unit 50, it may be possible to prevent the exposure of the electronic connector 400 in the inside of the vehicle, thereby preventing unnecessary exposure of wires, preventing the user's visual discomfort and ensuring aesthetics.

Additionally, in this embodiment, since the electronic connector 400 and the electronic slot 15 are connected with the fuse box 10 covered with the fuse box cover unit 50, there is no need to separate the fuse box cover unit 50 after the connection.

Accordingly, in this embodiment, it may be possible to eliminate the need for a space for the separated fuse box cover unit 50 after the connection of the electronic connector 400 and the electronic slot 15, and to solve the aesthetic problem caused by the separated fuse box cover unit 50.

Hereinafter, the fuse box cover unit 50 will be described in more detail.

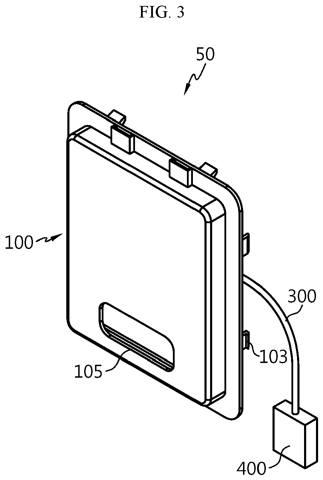

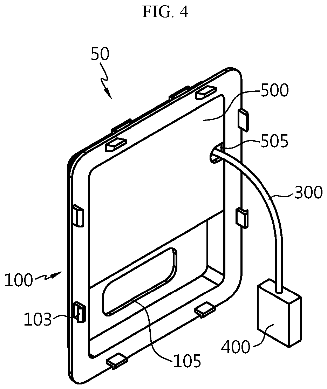

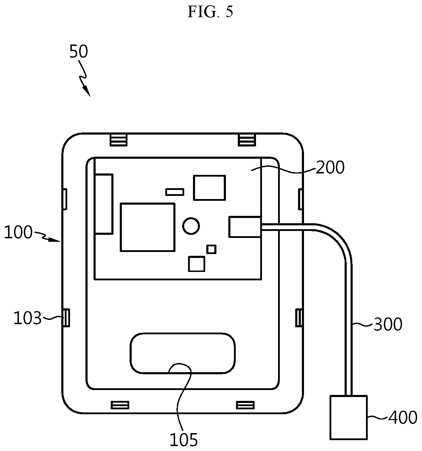

FIG. 3 is a diagram illustrating the fuse box cover unit of the terminal coupling apparatus for vehicles of FIG. 2, FIG. 4 is a schematic rear perspective view of the fuse box cover unit of FIG. 3, and FIG. 5 is a diagram of the fuse box cover unit of FIG. 4 excluding a printed circuit board (PCB) case.

Referring to FIGS. 3 to 5 and FIGS. 1 and 2, the fuse box cover unit 50 may include a cover body 100, an electronic PCB 200, a connection wire 300 and the electronic connector 400.

The cover body 100 may form an appearance of the fuse box cover unit 50, and be detachably coupled to the fuse box 10. When coupled to the fuse box 10, the cover body 100 may seal the fuse box 10.

The rear surface of the cover body 100 may have an accommodation space in which the electronic PCB 200 as described below is received. The accommodation space may be larger than the thickness of the electronic PCB 200 to prevent the electronic PCB 200 from sticking out of the cover body 100 when the electronic PCB 200 as described below is mounted.

Hereinafter, the cover body 100 will be described in more detail.

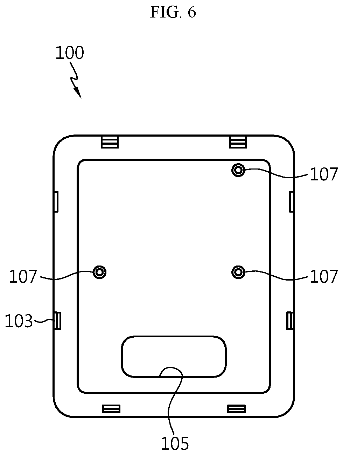

FIG. 6 is a diagram illustrating the cover body of the fuse box cover unit of FIG. 4.

Referring to FIGS. 6 and FIGS. 1 to 5, the cover body 100 may include a cover hook 103, a cover handle 105 and a PCB fixing portion 107.

The cover hook 103 may be formed in the edge of the cover body 100, and include one or more cover hooks 103. Hereinafter, this embodiment is described based on the plurality of cover hooks 103.

The plurality of cover hooks 103 may be hook-coupled to the edge of the fuse box 10 to guide more stable fixing of the cover body 100 to the fuse box 10 when coupling the fuse box cover unit 50 to the fuse box 10.

The cover handle 105 may be configured to guide user manipulation. The cover handle 105 may be formed in the cover body 100, and have a slot shape of a predetermined size. Specifically, the cover handle 105 may be formed at the central lower part of the cover body 100, and have an open slot shape of a sufficient size to allow the user's hand to pass through.

The PCB fixing portion 107 may be configured to fix the electronic PCB 200 as described below. The PCB fixing portion 107 may be disposed in the rear surface of the cover body 100, and include one or more PCB fixing portions 107. Hereinafter, this embodiment is described based on the plurality of PCB fixing portions 107.

The plurality of PCB fixing portions 107 may have a boss shape having a groove of a predetermined depth. The electronic PCB 200 as described below may be inserted into the plurality of PCB fixing portions 107. Through the plurality of PCB fixing portions 107, the electronic PCB 200 as described below may be fixed to the cover body 100 more stably.

The electronic PCB 200 may be disposed on the rear surface of the cover body 100. In this embodiment, the electronic PCB 200 may be mounted in the cover body 100 so that the electronic PCB 200 may be integrally provided with the fuse box cover unit 50.

The electronic PCB 200 may be an OBD circuit board for diagnosis or management of the vehicle, and may be, for example, an OBD electronic system. The electronic PCB 200 may include an OBD data collection unit.

The electronic PCB 200 may have a wireless communication module mounted thereon to support wireless communication. The wireless communication module may guide wireless connection to the vehicle's electronic device or the user's smartphone or tablet.

The connection wire 300 may be connected to the electronic PCB 200, and have a predetermined length. Specifically, one end portion of the connection wire 300 may be connected to the electronic PCB 200, and the electronic connector 400 as described below may be disposed at the other end portion of the connection wire 300.

The electronic connector 400 may be mounted at the end portion of the connection wire 300, and connected to the electronic PCB 200 through the connection wire 300. Specifically, the electronic connector 400 may be mounted at the other end portion of the connection wire 300. The electronic connector 400 may be an OBD connector.

The fuse box cover unit 50 may include the PCB case 500.

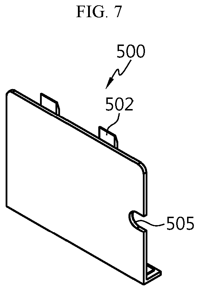

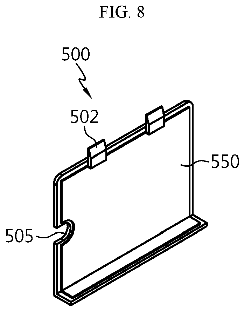

FIG. 7 is a diagram illustrating the PCB case of the fuse box cover unit of FIG. 3, and FIG. 8 is a schematic rear perspective view of the PCB case of FIG. 7.

Referring to FIGS. 7 and 8 and FIGS. 1 to 6, the PCB case 500 may cover the electronic PCB 200. The PCB case 500 may cover the electronic PCB 200 together with the cover body 100 to prevent the exposure of the electronic PCB 200 to the outside of the fuse box cover unit 50.

The PCB case 500 may have a cover connection portion 502 and a wire groove 505.

The cover connection portion 502 may be configured to fix the PCB case 500 more stably when connecting the PCB case 500 to the cover body 100, and be disposed on top of the PCB case 500.

The cover connection portion 502 may protrude from the upper end portion of the PCB case 500 to a predetermined length. The cover connection portion 502 may include one or more cover connection portions 502. Hereinafter, this embodiment is described based on a pair of cover connection portions 502.

The pair of cover connection portions 502 may protrude from the upper end portion of the PCB case 500, and be spaced a predetermined distance apart from each other. The pair of cover connection portions 502 may be inserted into the upper end portion of the cover body 100 to fix the PCB case 500 to the rear surface of the cover body 100 more firmly.

The wire groove 505 may allow the connection wire 300 to pass through, and be formed at one side of the PCB case 500 in a shape of a predetermined curved groove to allow the connection wire 300 to pass through.

Meanwhile, the PCB case 500 may include an electromagnetic wave shielding material 550.

The electromagnetic wave shielding material 550 may be configured to reduce the influence of noise from the electronic components of the vehicle and improve antenna directivity during wireless communication. The electromagnetic wave shielding material 550 may include an electromagnetic wave shielding sheet 550 and be attached to the inner surface of the PCB case 500.

Accordingly, in this embodiment, through the electromagnetic wave shielding material 550, during wireless communication via the electronic PCB 200, it may be possible to minimize the influence of noise from the vehicle, and significantly improve antenna directivity towards the front side of the fuse box cover unit 50 in the inside of the vehicle, i.e., in the outward direction, not in the inward direction, of the vehicle during wireless communication.

Meanwhile, the PCB case 500 itself may be made of a material having the electromagnetic wave shielding function without attaching the electromagnetic wave shielding material 550 to the PCB case 500.

Hereinafter, the connection of the OBD electronic system and the interference prevention mechanism through the fuse box cover unit 50 will be described in more detail.

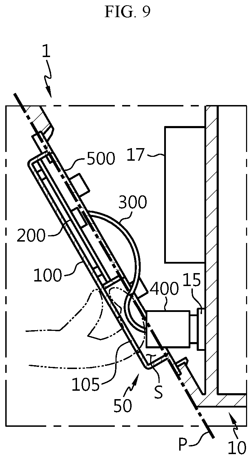

FIG. 9 is a diagram illustrating the interference prevention mechanism through the fuse box cover unit of FIG. 2.

Referring to FIG. 9, the existing fuse box cover is disposed on the line indicated by p when mounted in the fuse box 10. Accordingly, the existing fuse box cover cannot cover the fuse box 10 when the electronic connector 400 is mounted due to interferences with the electronic connector 400.

In the case of the fuse box cover unit 50 according to this embodiment, the cover body 100 may protrude in the frontward direction from the edge of the fuse box 10 to a predetermined depth to form a predetermined space (s) on the rear surface of the cover body 100 when the fuse box cover unit 50 is mounted in the fuse box 10. The predetermined space (s) may form an interference prevention space to prevent interferences with the electronic connector 400.

Accordingly, the fuse box cover unit 50 according to this embodiment may prevent interferences with the electronic connector 400 when connecting the electronic connector 400 to the electronic slot 15, so that the fuse box cover unit 50 may cover the fuse box 10 even after the electronic connector 400 is mounted.

Accordingly, in this embodiment, since the fuse box cover unit 50 may cover the fuse box 10 after the electronic connector 400 is connected to the electronic slot 15 of the fuse box 10, it may be possible to maintain the electrical connection of the OBD electronic system in a state that the fuse box cover unit 50 is coupled to the fuse box 10 without the exposure of wires or the like.

Additionally, since the fuse box cover unit 50 includes the OBD electronic system such as the electronic PCB 200 and the electronic connector 400 integrally provided, it may be possible to modularize the electronic device such as the OBD electronic system in the fuse box cover unit 50.

Furthermore, since the electronic PCB 200 is disposed above the cover handle 105 on the rear surface of the fuse box cover unit 50, it may be possible to prevent interferences caused by the electronic PCB 200 when the user manipulates the cover handle 105.

Hereinafter, the connection of the electronic connector 400 to the fuse box cover unit 50 will be described in more detail.

When connecting the electronic connector 400 to the electronic slot 15, the user connects the electronic connector 400 on the rear surface of the fuse box cover unit 50 to the electronic slot 15 in the fuse box 10. Subsequently, the user fixes the cover body 100 of the fuse box cover unit 50 to the fuse box 10 to seal the fuse box 10.

As described above, in this embodiment, since the connection of the OBD electronic system is established with the fuse box 10 covered with the fuse box cover unit 50, there is no need to separate the fuse box cover unit 50 after OBD connection, thereby preventing the exposure of the internal components of the vehicle such as wires and overcoming visual discomfort.

Additionally, since the fuse box 10 may be kept covered with the fuse box cover unit 50 during the connection, it may be possible to prevent dead space formation in the internal space of the vehicle due to the separated fuse box cover unit 50.

Meanwhile, after the user puts the hand in the cover handle 105 of the cover body 100, the user may perform the operation of fixing the cover body 100 to the fuse box 10 or separating from the fuse box 10 more easily.

In this instance, since the electronic PCB 200 is disposed above the cover handle 105 on the rear surface of the cover body 100, it may be possible to prevent interferences with the electronic PCB 200 when the user manipulates the cover handle 105.

Additionally, since the cover handle 105 is in a shape of an open slot, the predetermined interference prevention space(s) may be formed behind the cover handle 105 together with the open space, thereby effectively ensuring the space for the user's easy manipulation.

While the present disclosure has been hereinabove described with regard to a limited number of embodiments and drawings, the present disclosure is not limited thereto and it is apparent that a variety of changes and modifications may be made by those skilled in the art within the technical aspect of the present disclosure and the scope of the appended claims and their equivalents.

The terms indicating directions such as upper, lower, left, right, front and rear are used for convenience of description, but it is obvious to those skilled in the art that the terms may change depending on the position of the stated element or an observer.

## Claims

1. A fuse box cover unit which seals a fuse box mounted in an inside of a vehicle, wherein an electronic connector connectable to an electronic slot formed in the fuse box is integrally formed.

2. The fuse box cover unit according to claim 1, wherein the electronic connector is disposed on a rear side of the fuse box cover unit opposite a front side that is exposed to the inside of the vehicle when the fuse box cover unit is mounted.

3. The fuse box cover unit according to claim 1, wherein the fuse box cover unit includes:
a cover body that is detachably coupled to the fuse box;
an electronic PCB disposed on a rear surface of the cover body;
a connection wire of a predetermined length connected to the electronic PCB; and
an electronic connector mounted at an end portion of the connection wire.

4. The fuse box cover unit according to claim 3, wherein the fuse box cover unit includes a PCB case covering the electronic PCB, and
wherein the PCB case has a wire groove to allow the connection wire to pass through.

5. The fuse box cover unit according to claim 4, wherein the PCB case includes an electromagnetic wave shielding material.

6. The fuse box cover unit according to claim 5, wherein the electromagnetic wave shielding material includes an electromagnetic wave shielding sheet and is attached to an inner surface of the PCB case.

7. The fuse box cover unit according to claim 3, wherein the fuse box cover unit includes a cover handle formed in the cover body and having slot shape of a predetermined size.

8. The fuse box cover unit according to claim 3, wherein the rear surface of the cover body has at least one PCB fixing portion for fixing the electronic PCB.

9. The fuse box cover unit according to claim 1, wherein the electronic connector is an OBD connector.

10. A terminal coupling apparatus for a vehicle, comprising:
the fuse box cover unit according to claim 1; and
a fuse box mounted in an inside of the vehicle.
